# EUROPEAN PATENT APPLICATION

(11) **EP 3 028 993 A1**
(43) Date of publication of application: **08.06.2016**
(21) Application number: 16153263.5
(22) Date of filing: 30.10.2008
(51) Int. Cl.: C01B 31/02, B82B 3/00, H01L 51/00, H01L 29/772, H01L 31/0224

(54) **A DEPOSIT AND ELECTRICAL DEVICES COMPRISING THE SAME**

(30) Priority: 30.10.2007 FI 20075767
(62) Divisional of application: 08843512.8
(71) Applicant: Canatu Oy, 00390 Helsinki (FI)
(72) Inventor: ROOS, Aappo, 00140 Helsinki (FI)
(74) Representative: Papula Oy

(57) **Abstract**

A deposit of material according to the present invention comprises carbon nanobud molecules. The carbon nanobud molecules are bonded to each other via at least one fullerene group (2). An electrical device according to the present invention comprises a deposit comprising carbon nanobud molecules. The electrical device according to the present invention may be e.g. a transistor (18), a field emitter (17, 19), a transparent electrode (15, 24, 28, 30), a capacitor (31), a solar cell (32), a light source, a display element or a sensor (33).

## Description

### FIELD OF THE INVENTION

The present invention relates to electronics, microelectronics and electronic materials. Especially the present invention relates to a deposit of material used in different kinds of electronic devices.

### BACKGROUND OF THE INVENTION

New materials are continuously required to produce faster, more efficient and less expensive electrical components. For example, as the characteristic dimensions in microelectronics components continue to shrink towards the nano-scale, new materials may be required to take into account quantum-mechanical effects occurring specifically at this atomic scale.

Due to the two-dimensional nature of processing technologies in the electronics and microelectronics industries, the use of new materials in the form of layered structures, films or other deposits is of particular importance. Conventional materials are often limited in their electrical, thermal and mechanical stability. Furthermore the reliable fabrication of electrically conductive continuous metallic layers, films or deposits with a thickness of below 10 nm is difficult with currently known deposition methods. These very thin deposits are especially sensitive to thermal damage and electromigration caused by high current densities in the deposit. The lack of stability of conventional films and other deposits also causes diffusion of the film material into adjacent regions of a device resulting in degradation of the device performance and even failure. As the dimensions of microelectronics devices shrink towards the nanoscale the problem of material diffusion becomes even more pronounced.

In addition to the generic beneficial properties of good electrical, thermal and mechanical stability, there exist several important material requirements for deposits depending on the specific application in which the deposit is to be used. In, for example, field effect transistors (FETs), the material forming the channel must possess high on-off ratios and high electron mobility in order to comply with the high switching speeds required in state-of-the-art data processors. A low work function is required for deposits that are used as field emitters in for example field emitting displays (FEDs). In addition to the obvious optical requirements, deposits used as transparent electrodes have the requirement of high conductivity which would result in a low sheet resistance. The transparent conductive deposits or electrodes are further used in for example displays (such as FEDs, LCDs, plasma displays and cathode ray tubes), solid state light sources, solar cells, touch screens and charge dissipating surfaces and in, for instance, electromagnetic shielding. In supercapacitors there exists a need for electrically stable, porous, and highly conductive deposits for the electrode material. The electrodes in solar cells require highly conductive material with good transparency to solar radiation. Furthermore, various sensors require *e.g*. conductivity to vary with environmental conditions. In all of the aforementioned devices mechanical flexibility of a deposit would bring further flexibility to the design of such devices. Furthermore mechanically flexible deposits would enable the fabrication of devices such as flexible solar cells, flexible displays etc.

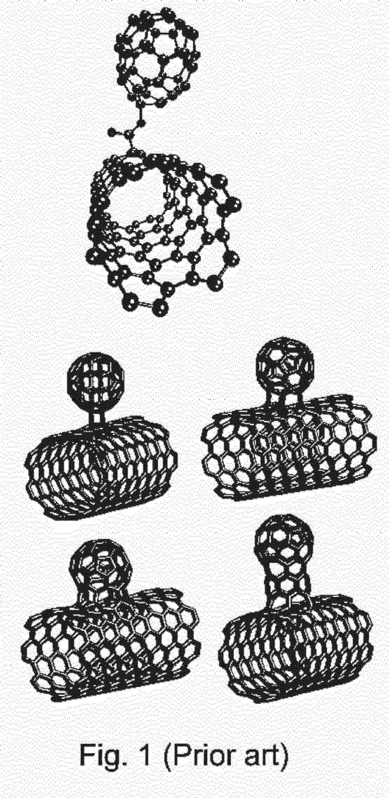

In publication PCT/FI2006/000206 a new type of carbon-based molecule and a method to synthesize the same is presented. These molecules, hereinafter referred to as carbon nanobuds or carbon nanobud molecules, have fullerene or fullerene-like molecules covalently bonded to the side of a tubular carbon molecule (Fig. 1). On a molecular level carbon nanobuds are disclosed in the publication to possess interesting electrical properties.

Using individual carbon nanobud molecules in electrical devices is difficult since it is difficult to control the orientation of the molecule at a certain location with sufficient accuracy. Furthermore using a single molecule at a certain point in a device requires that the molecule be of predetermined length and crystal structure which is also very difficult to control. In some devices, *e.g.* in solar cells and in supercapacitors, the volume or the amount of material simply has to be sufficiently large so that the use of a single molecule is not feasible.

As explained above it is obvious that, in the art, there exists a strong need for new types of more stable deposits with other device-specific properties to be used in electrical components for *e.g*. carrier transport and carrier storage. This need is expected to grow as the characteristic dimensions of electrical components shrink in size and their speed and efficiency improves.

### PURPOSE OF THE INVENTION

The purpose of the present invention is to reduce the aforementioned technical problems of the prior-art by providing a new type of deposit and improved electrical device structures utilizing the new type of deposit.

### SUMMARY OF THE INVENTION

The present invention is characterized by what is presented in independent claims 1 and 7.

The deposit of material according to the present invention comprises carbon nanobud molecules. The carbon nanobud molecules are bonded to each other via at least one fullerene group.

The electrical device according to the present invention comprises a deposit comprising carbon nanobud molecules.

An individual carbon nanobud molecule comprises mainly carbon atoms but the molecules may be functionalized with groups containing other elements. Hence the deposit comprising carbon nanobud molecules contains carbon atoms for the most part but other elements may be incorporated into the deposit during functionalization and as impurities.

The carbon nanobud molecules in the deposit and in the electrical device according to the present invention take the form of a network in which the molecules may be randomly distributed or fully or partially aligned. In one embodiment of the present invention the carbon nanobud molecules form a network of electrically conductive paths in the deposit of material according to the present invention.

In another embodiment of the present invention the carbon nanobud molecules form an essentially parallel array of electrically conductive paths in the deposit of material according to the present invention. These essentially parallel conductive paths provide a way to fabricate a plurality of single-molecule electrical devices in parallel which can be used to reduce the dependency of *e.g*. a circuit from the operation of one device.

A random distribution or parallel array of carbon nanobud molecules in a film or other deposit ensures that the deposit of these molecules contains many possible paths for current flow. The deposit also provides a statistically large number of molecules so that the effects of variation in the properties of individual molecules are suppressed. Therefore the deposit comprising carbon nanobud molecules according to the present invention is not dependent on the functioning of an individual molecule. This improves the reliability of devices exploiting deposits comprising carbon nanobud molecules as opposed to devices in which the flow of current depends on an individual conducting molecule.

In an electrical device according to one embodiment of the present invention a deposit comprising carbon nanobud molecules serves the function of carrier transport or carrier storage.

The deposits comprising carbon nanobud molecules according to the present invention may be deposited using the commonly known methods of *e.g*. filtration from gas phase or from liquid, deposition in a force field and deposition from a solution using spray coating or spin drying. The carbon nanobud molecules can also be suspended in solution and sprayed or spin coated onto *e.g*. a silicon wafer to form *e.g*. a film. The carbon nanobud molecules can also be grown on a surface. The deposit can be further patterned to form a special shape. In one embodiment of the present invention the deposit of material according to the present invention is a volume, a film or a wire of material.

In another embodiment of the present invention the deposit of material according to the present invention has a thickness between 1 nanometre and 10 centimetres and preferably a thickness between 1 nanometre and 100 micrometres.

Compared to conventional deposits of conductive or semiconductive material, the deposits comprising carbon nanobuds according to the present invention possess superior electrical, thermal and mechanical stability. These properties are particularly important in deposits which are used for carrier transport in electrical devices. The stability requirements become even more pronounced in electrical devices with small physical size or in flexible devices or in electrical devices operating in severe environments.

In one embodiment of the present invention the carbon nanobud molecules are bonded to each other via at least one fullerene group in the deposit of material according to the present invention.

The reason for the stability of the deposit according to the present invention is the ability of a fullerene group to bond to the side of the tubular part or to a fullerene group of other carbon nanobud molecules directly or via a bridge molecule. The strong intermolecular bonding enabled by the fullerene groups efficiently prevents the slipping of individual molecules with respect to each other. The stability of the deposit according to the present invention is further enhanced by the strong intramolecular covalent bonds of a carbon nanobud molecule. The bonds can also act as low resistivity junctions between molecules lowering the overall resistance of the network.

In addition to the stability of the deposit comprising carbon nanobud molecules, the deposit possesses many other device-specific beneficial characteristics resulting from the unique bonding scheme of the deposit according to the present invention. These characteristics including *e*.*g*. a low work function, mechanical flexibility, a nanoporous structure, high conductivity, controllable conductivity and semiconductivity and high carrier mobility can be utilized in an electrical device according to the present invention.

In one embodiment of the present invention the carbon nanobud molecules are functionalized via at least one fullerene group in the deposit of material according to the present invention. This functionaliziation may be, for instance, by a dye or otherwise photo active functional group so as to provide a means of exciting an electron by means of electromagnetic radiation or to change the conductivity or band gap of the deposit comprising carbon nanobud molecules.

In one embodiment of the present invention the deposit of material according to the present invention has a low work function resulting in electron emission with a threshold electric field of below 10 Volts per micrometer, preferably with a threshold electric field of below 2 Volts per micrometer and most preferably with a threshold electric field of below 1 Volt per micrometer.

In another embodiment of the present invention the deposit of material according to the present invention has an on-off ratio above 1, preferably above 1x10² and most preferably above 1x10⁴. The on-off ratio is defined here as the ratio of the conductivity of a semiconductive material during an external stimulus (the on-state) and the conductivity of a semiconductive material without an external stimulus (the off-state).

In another embodiment of the present invention the deposit of material according to the present invention has a conductivity in the range of 1x10⁻⁵-1x10⁸ S/m, preferably in the range of 0.1-1x10⁷ S/m and most preferably in the range of 1x10³-1x10⁶ S/m.

In another embodiment of the present invention the deposit of material according to the present invention has a sheet resistance in the range of 1x10⁻⁶-1x10⁴ Ohm/square, preferably in the range of 1x10⁻⁵-1x10³ Ohm/square and most preferably in the range of 1x10⁻⁴-1x10² Ohm/square.

In yet another embodiment of the present invention the deposit of material according to the present invention has a carrier mobility of above 10⁻⁵ cm²/(Vs), preferably above 10⁻³ cm²/(Vs) and most preferably above 10⁻¹ cm²/(Vs).

In yet another embodiment of the present invention the deposit of material according to the present invention is semiconductive having a bandgap in the range of 0.001 to 10 electron volts, preferably in the range of 0.01 to 5 electron volts and most preferably in the range of 0.1 to 1.0 electron volts.

In many electrical devices the use of a deposit comprising carbon nanobud molecules also reduces fabrication costs. For example, in the fabrication of FEDs having a large area, the conventional micro tip technology requires the usage of expensive semiconductor processing equipment. Also, the manufacturing of transparent electrodes from the conventional ITO is expensive in part due to the shortage and the high price of indium and due to the high temperature vacuum processes often needed for manufacturing ITO electrodes. The micro tip technology as well as transparent ITO electrodes could be replaced by using a deposit comprising carbon nanobud molecules as will be described below.

In one embodiment of the present invention the electrical device according to the present invention is a transistor or a field effect transistor. In these devices *e.g.* high on-off ratios, high conductivity and controllable semiconductivity may be required from the deposit comprising carbon nanobud molecules depending on the part of the device structure where the deposit resides.

In another embodiment of the present invention the electrical device according to the present invention is a transparent electrode. In this application *e.g.* a high lateral conductivity may be required from the deposit comprising carbon nanobud molecules. The transparent electrodes comprising carbon nanobud molecules may be used *e*.*g*. in displays, in light sources or in solar cells.

In yet another embodiment of the present invention the electrical device according to the present invention is a field emitter. A critical property of the deposit comprising carbon nanobud molecules in this application is the low work function which enables the emission of electrons from the deposit even with weak electric fields. This improves the efficiency of the field emitter structure.

In yet another embodiment of the present invention the electrical device according to the present invention is a light source, a display element, a capacitor, a solar cell or a sensor. These devices may take advantage of the deposit comprising carbon nanobud molecules in many ways. The devices may incorporate *e.g*. transparent electrodes and field emitters. A capacitor or a supercapacitor may take advantage of the nanoporous structure of the deposit comprising carbon nanobud molecules and a solar cell and a sensor may exploit the conductivity and/or the controllable semiconductivity of the deposit comprising carbon nanobud molecules. In particular a sensor but also the other electrical devices mentioned above may exploit the variable conductivity of a deposit comprising carbon nanobud molecules due to an external stimulus. More precisely the conductivity of the deposit may be affected by *e.g.* adsorption or other bonding of molecules adhering to the fullerene parts in the deposit. Also variations in temperature or radiation interacting with the deposit comprising carbon nanobud molecules may affect the conductivity of the deposit.

### DETAILED DESCRIPTION OF THE INVENTION

In the following, the present invention will be described in more detail with references to the accompanying figures, in which
Fig. 1 (Prior Art) presents five different molecular models for a carbon nanobud molecule in which a fullerene or fullerene-like molecule is covalently bonded to a tubular carbon molecule,
Fig. 2a schematically presents the arrangement of the carbon nanobud molecules in a deposit according to one embodiment of the present invention,
Fig. 2b schematically presents the random orientation of the carbon nanobud molecules according to one embodiment of the present invention.
Fig. 2c schematically presents the essentially parallel orientation of the carbon nanobud molecules according to one embodiment of the present invention.
Fig. 3 schematically presents a field effect transistor structure according to one embodiment of the present invention and
Fig. 4 schematically presents a lateral field emitter structure according one embodiment of the present invention.
Fig. 5 schematically presents a vertical field emitter structure according one embodiment of the present invention.
Fig. 6 schematically presents a capacitor structure according one embodiment of the present invention.
Fig. 7 schematically presents a solar cell structure according one embodiment of the present invention.
Fig. 8 schematically presents a sensor structure according to one embodiment of the present invention.
Figs. 9a to 9c schematically illustrate the fabrication of a field emission light source structure according to one embodiment of the present invention.
Figs. 10a to 10b schematically illustrate the fabrication of a solar cell according to one embodiment of the present invention.
Figs. 11a to 11b schematically illustrate the fabrication of a capacitor according to one embodiment of the present invention.
Figs. 12a to 12c schematically illustrate the fabrication of a capacitor according to one embodiment of the present invention.

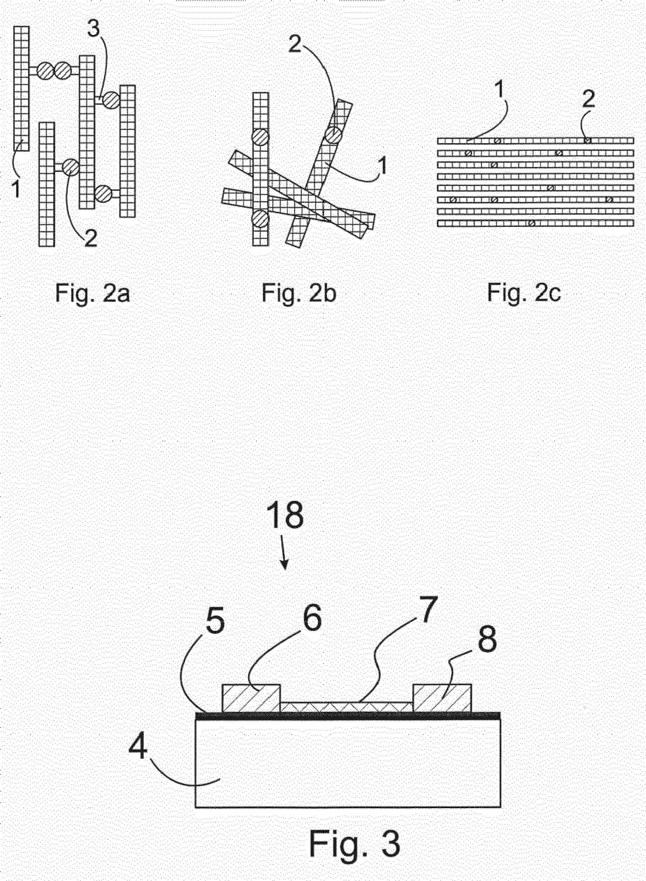

As depicted in Fig. 2a the carbon nanobud molecules may bond to the next carbon nanobud molecule in a deposit comprising carbon nanobuds via a fullerene or fullerene-like part 2 of the molecule. A fullerene or fullerene-like part 2 of the carbon nanobud molecule is covalently bonded to the outer side of the tubular part 1 of the same molecule. The bond or the bonding part 3 of the molecule may comprise several atoms as illustrated in Fig. 1. The bonding scheme in Fig. 2a is illustrated two-dimensionally, but the orientation of the individual carbon nanobud molecules may be random or aligned as illustrated in Figs. 2b and 2c, respectively.

The conductivity of an individual carbon nanobud molecule is controlled by the chirality of the tubular part 1 of the molecule and by the concentration of fullerene or fullerene-like molecules. Increasing the fullerene concentration increases the fraction of semiconducting tubes. This opens up the possibility to fabricate *e.g.* semiconductive or conductive (metallic) carbon nanobud molecules. Correspondingly by controlling the density, the length (in the direction of the conductive pathway), the width and the thickness of the deposit and the relative amount of conductive and semiconductive molecules in a deposit according to the present invention one can produce conductive or semiconductive deposits. The semiconductivity of the deposit can further be controlled in the same way.

A random distribution (Fig. 2b) or aligned orientation (Fig. 2c) of a plurality of carbon nanobud molecules in a film or other deposit ensures that the network of these molecules contains many possible paths for current flow in the deposit. Therefore the deposit comprising carbon nanobud molecules according to the present invention is not dependent on the functioning of an individual molecule. This improves the reliability of devices exploiting deposits comprising carbon nanobud molecules as opposed to devices in which the flow of current depends on an individual conducting molecule. According to one embodiment of the invention, partial alignment of the network can be used to increase or decrease the number of conductive pathways in a particular direction. Furthermore, according to one embodiment of the present invention the essentially parallel alignment of carbon nanobud molecules in the deposit according to the present invention provides a way to fabricate a plurality of single-molecule electrical devices in parallel. The essentially parallel conductive paths can be used to reduce the dependency of *e.g.* a circuit on the operation of one device.

Nanobud molecules may be aligned according to the following technique. An aerosol comprising nanobuds is introduced into a narrow slit, for instance, in a plate. The gap height is preferably less than 100 times the average length of the nanobud or nanotube bundle length and more preferably less than 50 times the average length of the nanobud or nariotube bundle length and most preferably less than 20 times the average length of the nanobud or nanotube bundle length. The gap length is preferably greater than 5 times the gap height and more preferably greater than 10 times the gap height and most preferably greater than 20 times the gap height. A substrate can be affixed in the gap to provide a means of depositing on a secondary substrate. Furthermore, the substrate can be cooled or charged to enhance the deposition by thermophoresis or electrophoresis.

A nanobud deposition unit for aligned deposition of nanobud molecules is constructed by affixing a flat metal plate 5 mm thick perpendicular the axis of a tube 1 cm in diameter such that an aerosol flow of nanobuds in a carrier gas must pass through slits in the plate. The metal plate has 5 parallel slits laser cut perpendicular to the face of the plate. The slits are 0.25 mm high and 7.0 mm wide and separated by 1 mm. An aerosol comprising nanobud bundles about 1 micrometer in diameter is introduced into the tube and flows through the slits, whereupon a fraction of the tubes, approximately aligned to the flow, deposits on the sidewalls of the slit.

The unique bonding scheme of Fig. 2a of a carbon nanobud deposit together with the molecular structure of an individual carbon nanobud molecule (see Fig. 1) results in a very useful set of properties for the deposit according to the present invention. The ability of a fullerene group to bond to another carbon nanobud molecule results in the exceptional electrical, thermal and mechanical stability of deposits comprising these molecules, and increases the separation of the tubular sections of the nanobud molecules, thus increasing nano-porosity and specific surface area. The strong intermolecular bonding efficiently prevents the slipping of individual molecules with respect to each other and increases charge transfer between individual molecules. The stability of the deposit according to the present invention is further enhanced by the strong intramolecular covalent bonds of a carbon nanobud molecule.

The ability to easily functionalized the carbon nanobud molecules allows, for instance, a dye or otherwise photo active functional group to be bonded to the molecule so as to provide a means of exciting an electron by means of electromagnetic radiation or to otherwise modify the function of molecules in a deposit comprising carbon nanobud molecules.

The properties of the deposit according to the present invention may include a low work function with field thresholds of *e.g*. around 0.65 V/µm, extremely high conductivity with a current carrying capacity of *e*.*g*. around 10¹⁰ A/cm² and an extremely high electron mobility of even up to *e.g.* 100000 cm²/(Vs). Additionally the carbon-based deposit comprising carbon nanobud molecules has a high thermal conductivity which alleviates problems related to heat extraction from high-power electrical devices. All of these properties are a result of the atomic structure of the deposit comprising carbon nanobud molecules. The carbon nanobud deposits combine and enhance the useful properties of carbon nanobud molecules and the advantages of using a carbon nanobud deposit instead of a single molecule in an electrical device, as discussed above.

The bonds between adjacent molecules in the carbon nanobud deposit may not be covalent but have an ionic nature or are of the Van der Waals type. Nevertheless a fullerene or fullerene-like part 2 of the molecule serves as an active group which can be further functionalized and is able to form strong bonds between individual carbon nanobud molecules. These molecular properties significantly simplify the fabrication of stable deposits from carbon nanobud molecules. The fullerene part 2 of the carbon nanobud molecule also brings asymmetry to the molecular structure which may help in aligning the molecules to a specific orientation during deposition of a deposit according to the present invention. Molecular alignment may be useful in tailoring *e.g*. the electrical properties of the deposit for a specific application. This type of manipulation of the deposit may also be used to locally control the conductivity of the deposit.

The deposits comprising carbon nanobud molecules according to the present invention may be deposited using commonly known methods of *e.g*. filtration from gas phase or from liquid, deposition in a force field and deposition from a solution using spray coating or spin drying. The carbon nanobud molecules can also be suspended in solution and sprayed or spin coated onto *e.g.* a silicon wafer to form *e.g*. a film. The carbon nanobud molecules can also be grown on a surface.

The FET structure 18 of Fig. 3 according to one embodiment of the present invention comprises a conductive gate layer 4 and an insulating layer 5 above the conductive gate layer 4. The device further comprises a source electrode 6, a drain electrode 8 and a channel layer 7 in between the source electrode 6 and the drain electrode 8 above the insulating layer 5. The channel layer 7 is in electrical contact with the source electrode 6 and the drain electrode 8. The channel layer 7 in the device is a semiconductive deposit comprising carbon nanobud molecules. Furthermore the conductive gate layer 4, the conductive source electrode 6 and the conductive drain electrode 8 may also comprise carbon nanobud molecules to enhance the mechanical, electrical and thermal properties of these layers or to simplify fabrication. The conductivity of the conductive gate layer 4, the conductive source electrode 6 and the conductive drain electrode 8 may be increased by increasing the amount of conductive nanobud molecules within the deposits.

The exemplary device in Fig. 3 according to one embodiment of the present invention operates like a conventional FET although the device structure 18 is inverted compared to conventional FET structures in the sense that the conductive gate layer 4 is below the source electrode 6 and the drain electrode 8. The channel layer 7 being a semiconductive deposit comprising carbon nanobud molecules provides the device with a channel of high conductivity in the on-state of the transistor and high electron mobility. This, together with high on-off ratios, enables superior performance including high switching speeds and reduced power consumption for the exemplary device 18 of Fig. 3 compared to conventional FET devices where the channel is made of *e.g*. single crystalline silicon. Furthermore the high thermal conductivity of the channel layer 7 enables more efficient heat extraction from devices operated at a high power. This brings flexbility to the design of FET structures. Furthermore the stability of the deposit comprising carbon nanobud molecules improves the reliability and increases the lifetime of the device.

The embodiment of Fig. 3 may also have the conductive gate layer 4 formed of *e*.*g*. p-doped silicon, and the insulating layer 5 may be *e*.*g*. silicon dioxide (SiO₂) or other insulating material with *e*.*g*. a higher dielectric constant κ. The source electrode 6 and the drain electrode 8 may also be of conductive material *e.g*. metal, but also, for instance, doped polysilicon may be used. The conductive gate layer 4, the source electrode 6 and the gate electrode 8 may also comprise carbon nanobud molecules to enhance the mechanical, electrical and thermal properties of these layers. Ultimately the choice of materials to realize the structure 18 of the embodiment of Fig. 3 is obviously governed by the requirements that transistor operation poses on the energy levels of carriers.

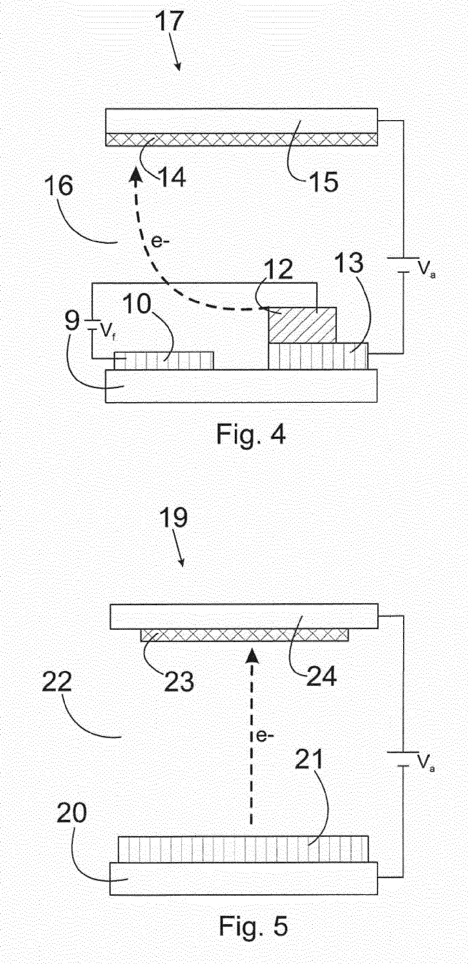

The deposit comprising carbon nanobud molecules possesses a low work function required for cold emission of electrons. This property may be exploited in *e.g*. a lateral field emitter structure 17 such as the one in Fig. 4. The structure 17 comprises an insulating substrate 9, an extracting electrode 10, a cathode electrode 13 and an electron emitter 12. The structure further comprises a vacuum gap 16 between the cathode electrode 13 and an anode electrode 15 and a light emitting layer 14 over the anode electrode 15. The electron emitter 12 may be a deposit comprising carbon nanobud molecules. The electron emitter 12 and the cathode electrode 13 are in electrical contact with each other. Furthermore the extracting electrode 10 and the cathode electrode 13 may also be deposits comprising carbon nanobud molecules.

When a voltage V_{f} is applied between the extracting electrode 10 and the cathode electrode 13 the electron emitter 12 emits electrons into the vacuum gap 16 between the cathode electrode 13 and the anode electrode 15. The electron emission occurs towards the extracting electrode 10 when the voltage V_{f} exceeds a threshold value dictated by the work function of the electron emitter 12. In the exemplary structure 17 of Fig.4 there is also a voltage Vₐ applied between the cathode electrode 13 and the anode electrode 15. After extraction from the electron emitter 12 the velocity vector of the extracted electron begins to turn towards the anode electrode 15 as a result of the electric field generated by Vₐ. The electric field in the vacuum gap 16 is such that electrons follow curved trajectories and eventually impinge on the light emitting layer 14 as illustrated in Fig. 4. The curvature of the electron trajectories depends on the ratio of the applied voltages V_{f} and Vₐ. The impinging electrons excite the light emitting layer 14 which may be *e*.*g*. of phosphorous material. The lateral field emitter structure 17 may be utilized as a light emitting component in *e.g*. field emitting displays (FEDs) or in solid-state lighting.

Fig. 5 presents another field emitter structure according to the present invention comprising deposit comprising carbon nanobud molecules. The device is a vertical field emitter structure 19 comprising a cathode electrode 20, an electron emitter 21, a vacuum gap 22, a light emitting layer 23 and an anode electrode 24. The electron emitter 21 may be a deposit comprising carbon nanobud molecules. The cathode electrode 20 and the electron emitter 21 are in electrical contact with each other. When a voltage Vₐ above a threshold value dictated by the work function of the electron emitter 21 is applied between the anode electrode 24 and the cathode electrode 20 the electron emitter 21 emits electrons over the vacuum gap 22 to the light emitting layer 23. The trajectories of the emitted electrons are essentially straight in this field emitter configuration 19. When the emitted electrons impinge on the light emitting layer 23 which is of *e.g*. phosphorous material, the light emitting layer 23 emits light. The vertical field emitter structure 19 may be utilized as a light emitting component in *e*.*g*. field emitting displays (FEDs) or in solid-state lighting.

The electron emitters 12, 21 being deposits comprising carbon nanobud molecules significantly improve the efficiency of the field emitter structures 17, 19. Compared to state-of-the-art technologies utilizing micro tips made of metals or conventional semiconductors a lower voltage is sufficient to extract electrons from the electron emitters 12, 21. This is due to the low work function of the deposit comprising carbon nanobud molecules. Accordingly a lower voltage Vₐ in the lateral field emitter structure 17 is also sufficient to produce the required curved trajectory for the electrons. The lower operating voltages Vₐ and V_{f} reduce the power consumption of the corresponding light emitting component in *e*.*g*. FEDs or solid state light sources. The high conductivity of the deposit comprising carbon nanobud molecules also reduces resistive losses in the field emitter structures 17, 19 further improving their efficiency. Furthermore the stability of the deposit comprising carbon nanobud molecules improves the reliability and increases the lifetime of the structures 17, 19. Moreover, the fact that the deposit need not be aligned with respect to the electric field simplifies and reduces the cost of fabrication.

Another example of an electrical device in which the deposit comprising carbon nanobud molecules can be applied is a transparent electrode. Incidentally the exemplary embodiments of Figs. 4 and 5 comprise such a device. The anode electrodes 15, 24 may be transparent so that the light emitted by the light emitting layers 14, 23 can be transmitted through the transparent electrodes 15, 24 with little loss towards a viewer of *e.g*. an FED or a light source.

A deposit comprising carbon nanobud molecules can be used as a transparent electrode since, due to the deposit's high conductivity, a low sheet resistance is attained even with very thin deposits. As the conductive deposit is very thin it is still able retain its transparency to light. Furthermore the stability of the deposit comprising carbon nanobud molecules improves the reliability and increases the lifetime of the transparent electrode.

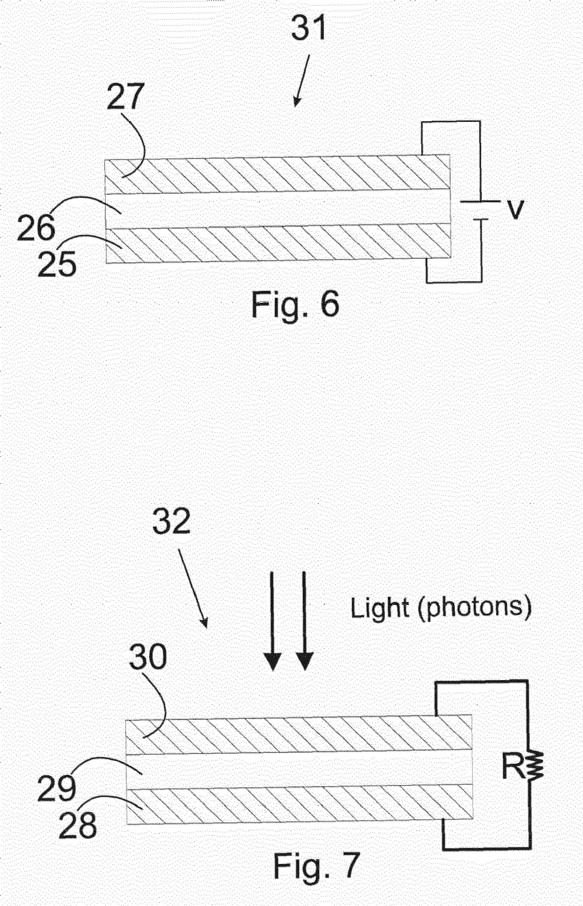

The exemplary capacitor (*e*.*g*. a supercapacitor) structure 31 of Fig. 6 comprises a first electrode 25, a second electrode 27 and an electrolyte layer 26 between the first electrode 25 and the second electrode 27. In this structure 31 either the first electrode 25 or the second electrode 27 or both of the electrodes 25, 27 may be deposits comprising an electrically conductive network of carbon nanobud molecules. In Fig. 6 the electrodes 25, 27 are connected to a power source which can be used to charge the capacitor 31. The electrolyte 26 may be a solid or a compressible ionic conductor that provides charge to the electrode-electrolyte interface from the side of the electrolyte 26. The tubular structure of an individual nanobud molecule results in a nanoporous structure for the electrodes 25, 27 which enables charge accumulation inside the pores. Furthermore the fullerene or fullerene-like parts 2 of the carbon nanobud molecules may act as separators between individual nanobud molecules in a deposit, as shown in Fig. 2a. This reduces the possible packing of individual molecules close to each other in the deposit, which further increases the surface area of the deposit. As a result the electrodes 25, 27 being deposits comprising an electrically conductive network of carbon nanobud molecules have a structure with an immense surface area for charge accumulation at the electrode-electrolyte interface, which increases the capacitance of the device 31. To efficiently take advantage of this surface area the electrolyte 26 is preferably of material that is able to penetrate the pores of the carbon nanobud deposit of the electrodes 25, 27. The high electrical conductivity and the good stability properties of the electrodes 25, 27 comprising a network of carbon nanobud molecules further improve the reliability and the efficiency of a capacitor or a super capacitor. A discharge capacitance of ~750F/g in 6M KOH solution has been measured for a deposit of carbon nanobud molecules according to one embodiment of the present invention.

The solar cell structure 32 schematically presented in Fig. 7 comprises a semiconductive layer 29 sandwiched in between two electrically conductive electrodes 28, 30. All of the layers 28, 29, 30 may comprise a network of carbon nanobud molecules. In the electrodes 28, 30 an electrically conductive network of carbon nanobud molecules may be used to form a transparent conductive layer which permits electromagnetic radiation to pass with little absorption. These electrodes 28, 30 enabled by the deposit comprising carbon nanobud molecules possess a high lateral conductivity required for efficient low-loss solar cell operation.

The semiconductive layer 29 in Fig. 7 comprises a semiconductive network of nanobud molecules the electrical conductivity of which may be controlled by the chirality of the nanobud molecules as discussed above. In a network of carbon nanobud molecules the strong intermolecular bonding via the fullerene group increases charge transfer between individual nanobud molecules providing a highly conductive path for carriers throughout the network. In the semiconductive layer 29 the increased charge transfer reduces resistive losses as charges are collected to the transparent electrodes. The fullerene part of the carbon nanobud molecules further enables the functionalization of the molecules to increase the absorption of electromagnetic radiation so as to, for instance, excite electrons from the valence band to the conduction band in the semiconductive layer 29. The high electrical conductivity of the electrodes 28, 30 and the good stability properties of all of the layers 28, 29, 30 comprising a network of carbon nanobud molecules further improve the reliability and the efficiency of the solar-cell structure 32.

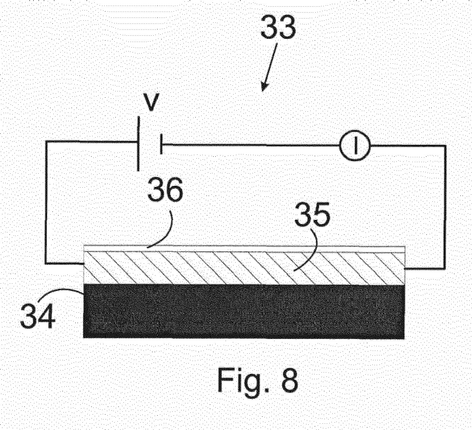

The sensor structure 33 schematically presented in Fig. 8 comprises a substrate 34, a conductive or semiconductive layer 35 and a protective coating 36, if required. The layer 35 in Fig. 8 comprises a network of nanobud molecules, which may be functionalized via a fullerene part to *e.g*. enhance the layer's and the sensor's responsivity to electromagnetic radiation or other external stimuli. Additionally since the conductivity or semiconductivity of the layer 35 comprising carbon nanobud molecules is controllable as discussed above the sensor structure 33 may be tailored to be sensitive to various kinds of stimuli in various kinds of environments. Furthermore in a network of carbon nanobud molecules the strong intermolecular bonding via the fullerene group increases charge transfer between individual nanobud molecules providing a highly conductive path for carriers throughout the network. The increased charge transfer in the semiconductive layer 35 reduces resistive losses in the device 33. The good stability properties of the nanobud layer 35 comprising carbon nanobud molecules further improves the reliability and the efficiency of the sensor structure 33.

The exemplary sensor structure 33 operates resistively. A voltage is connected over the deposit 35 while an external stimulus, *e*.*g*. electromagnetic radiation, alters the conductivity of the nanobud layer 35. The changes in conductivity can be observed *e.g*. by measuring the current (I) flowing *e.g*. laterally through the nanobud layer 35 as illustrated in Fig. 8.

In one embodiment of the invention the nanobud layer 35 may stand alone in a sensor structure in the sense that no substrate 34 is needed to support the other layers of the structure. Furthermore, external stimuli to the sensor structure according to the present invention may be *e.g*. in the form of a field, for instance, electric field, temperature, radiation, for instance, electromagnetic radiation, or adsorbed or bonded molecules and so the device can serve *e*.*g*. as an electric field, radiation, temperature or gas or liquid sensor. Moreover, as the density of the deposit comprising carbon nanobud molecules can be modified by the application of an external force or pressure and thus change the number and quality of interconnects between nanobud molecules, such a deposit can serve *e.g*. as a pressure sensor or accelerometer.

The thickness of the deposits comprising carbon nanobud molecules in the above examples may be *e.g*. in the range of 1 nm to 10 cm. In this range the deposits comprising carbon nanobud molecules are feasible to fabricate and continuous so the deposit's properties do not suffer from discontinuities in the deposit.

### EXAMPLES OF FABRICATION

In the following the fabrication of electrical devices comprising carbon nanobud molecules is described in detail. The following methods are presented as examples for some embodiments of the present invention. The nanobud molecules used in the examples are commercially available from Canatu Oy and can be synthesized using the method disclosed in patent application publication WO/2007/057501. In order to synthesize carbon nanobud molecules with a fullerene concerntration of 1 fullerene per nm, the H₂O and CO₂ concentrations in the synthesis reactor, in the method disclosed in publication WO/2007/057501, are 135 ppm and 4000 ppm, respectively. The corresponding H₂O and CO₂ concentrations to synthesize carbon nanobud molecules with a fullerene concentration of 1 fullerene per 10 nm are 100 ppm and 500 ppm, respectively.

### Transparent Electrode

A transparent electrode according to one embodiment of the present invention is manufactured according the following procedure. A nanobud synthesis reactor is operated at a furnace set temperature of 1000 °C. The nanobud product is collected on a nitrocellulose filter and the reactor is operated at conditions where the nanobud product has a concentration of approximately 1 fullerene per 10 nm. The resulting film is pressed against a transparent PE substrate outside the synthesis reactor, and the deposit is transferred from the nitrocellulose filter to the PE substrate at room temperature. The resulting layer is first dipped in ethanol and then in nitric acid. The nitric acid treatment increases the conductivity of the nanobud layer by about ten times and the ethanol treatment increases the conductivity of the nanobud layer by an additional five times. These treatments do not affect the transparency of the nanobud layer. As an example the sheet resistance of the resulting nanobud film was measured to be about 500 ohms/square, 100 ohms/square and 30 ohms/square for a transmittance of 90%, 50% and 40% at 550 nm wavelength, respectively. The transparent electrodes comprising carbon nanobud molecules fabricated with the disclosed method may be used e.g. in displays, in light sources or in solar cells.

### Field Effect Transistor

A bottom gate field effects transistor according to one embodiment of the present invention is manufactured according the following procedure. A bottom-gate transistor is fabricated by depositing nanobud networks having a concentration of approximately 1 fullerene per nanometer on a highly B-doped Si substrate coated with a thermally grown SiO2 (100 nm), acting as a gate dielectric. A 300 nm layer of Pt is sputtered on the back-side for better conductivity. Prior to the nanobud deposition, a photolithography step of AZ polymer deposition with open windows is performed. After the lift-off in acetone the nanobud network is patterned on the substrate. Subsequently a second photolithography step deposits PMMA with open windows for subsequent metal electrode deposition. The source and drain electrodes (30 nm Ti and 200 nm Au) contacting the nanobud transistor channels are deposited using electron beam evaporator. Then the lift-off process to remove the AZ polymer and unnecessary metal is performed.

### Sensor

A sensor according to one embodiment of the present invention is manufactured according the procedure similar to FET manufacturing procedure. Sensors are fabricated by depositing nanobud networks on a highly B-doped Si substrate coated with a thermally grown SiO2 (100 nm), acting as a gate dielectric. Prior to the nanobud deposition, the source and drain electrodes (30 nm Ti and 200 nm Au), for further contacting the nanobud network channels, are deposited using an electron beam evaporator. In order to avoid the electrical contacts between different sensor devices excessive CNTs are etched by laser. A 300 nm layer of Pt is sputtered on the back-side for better conductivity, and the Pt layer can be used to bias the gate electrode. The sensors can be operated either in the gas or liquid phases to sense gaseous and liquid molecules.

### Field Emission Light Source

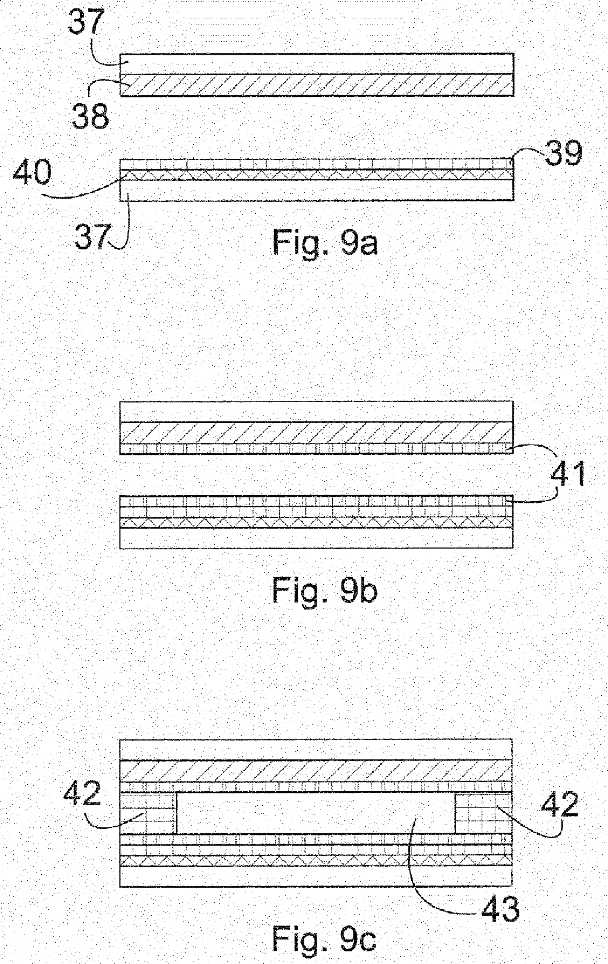

A field emission light source according to one embodiment of the present invention is manufactured according to the following procedure. The procedure is schematically presented by the series of Figs. 9a to 9c, where Fig. 9a represents the cross sectional structure of the device in the beginning of the process, and Fig. 9c represents the cross sectional structure of the device at the end of the process. The device can be a "stand alone" device or be all or part of a pixel in a display device. A nanobud synthesis reactor is operated at a furnace set temperature of 1000 °C. The product is collected on two nitrocellulose filters, and the reactor is operated at conditions where the nanobud product has a concentration of approximately 1 fullerene per nm. One of the resulting films 41 is pressed against a gold substrate 39 at a temperature of 100 C, and the deposit is transferred from the filter to the gold substrate 39. A glass substrate 37 (e.g. 1 cm^2 and .5 mm thick) is epoxyed to the nanobud coated gold substrate 39 and an epoxy layer 40 is left in between the glass substrate 37 and the gold layer 39. A second nanobud film 41 is pressed against a glass substrate 37 coated with a P20 ((Zn,Cd)S:Ag) phosphor 38 and the nanobud deposit 41 is transferred from the filter to the phosphor coated glass substrate 37 at room temperature. Gold electrodes (not shown in the figures) are sputtered at two opposing edges of the nanobud and phosphor coated glass 37. The resulting layered substrate with the phosphor 38 and nanobud 41 coatings is first dipped in ethanol and then in nitric acid. The first and second substrates are glued together with the nanobud coated surfaces 41 facing inward in high vacuum to create a vacuum gap 43 between them using spacer elements 42. When a current is applied between the two coated substrates on each side of the vacuum gap 43, the device operates as a light source.

### Solar Cell

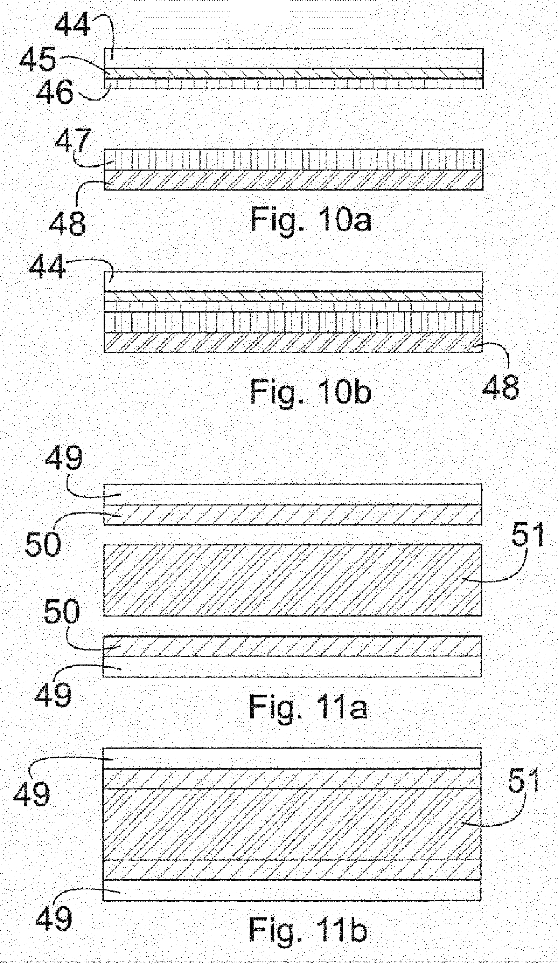

A solar cell according to one embodiment of the present invention is manufactured according the following procedure. The procedure is schematically presented by the series of Figs. 10a to 10b, where Fig. 10a represents the cross sectional structure of the device in the beginning of the process, and Fig. 10b represents the cross sectional structure of the device at the end of the process. A nanobud synthesis reactor is operated at a furnace set temperature of 1000 °C, and the reactor is operated at conditions where the nanobud product has a concentration of approximately 1 fullerene per 10 nm. The product is collected on a nitrocellulose filter. The resulting nanobud film 45 is pressed against a transparent PE substrate 44 and the deposit 45 is transferred from the filter to the PE substrate 44 at room temperature. The resulting first nanobud layer 45 is first dipped in ethanol and then in nitric acid to create a transparent electrode. A second layer of nanobuds 46 collected from nanobud synthesis reactor operated at a furnace set temperature of 1000 °C, and at conditions where the nanobud product has a concentration of approximately 1 fullerene per nm is prepared on a glass filter. The sample is submerged in a 20 wt% solution of polyethylene imine (PEI) in methanol overnight, followed by thorough rinsing with methanol. The sample is then dipped in a photosensitive ruthenium-polypyridine dye and ethanol. After soaking the film in the dye solution and then drying, a thin layer of the dye is left covalently bonded to the surface of the nanobuds. The nanobud-dye-layer 46 is then transferred to the transparent electrode and on the first nanobud layer 45 by pressing the two nanobud layers together. A separate backing is made with a thin layer of iodide electrolyte 47 spread over a conductive platinum sheet 48. The front part with the nanobud layers 45, 46 and the back part with the iodide electrolyte 47 on a platinum sheet 48 are then joined and sealed together to prevent the electrolyte 47 from leaking. This structure is used as a solar cell.

### Solar Cell

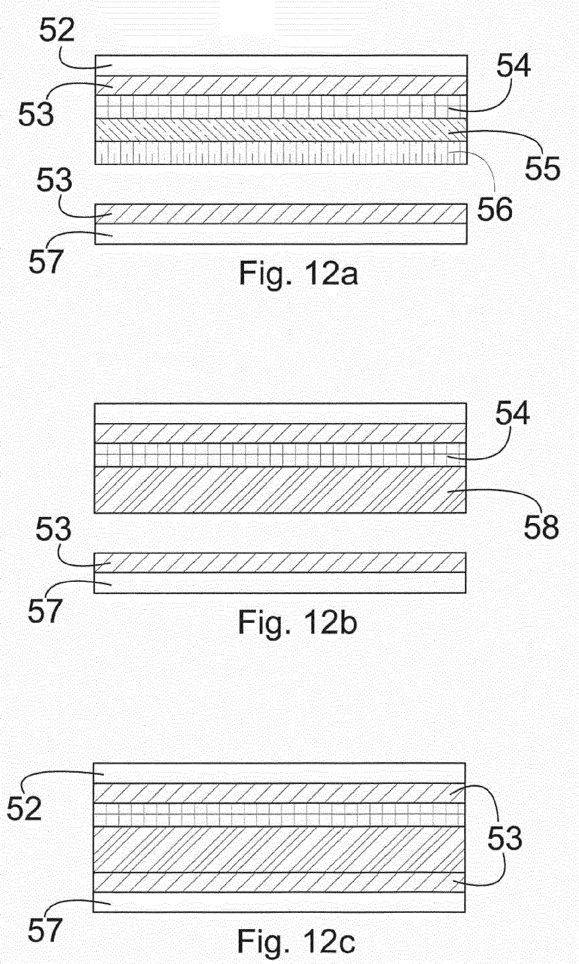

A solar cell according to one embodiment of the present invention is manufactured according the following procedure. The procedure is schematically presented by the series of Figs. 12a to 12c, where Fig. 12a represents the cross sectional structure of the device in the beginning of the process, and Fig. 12c represents the cross sectional structure of the device at the end of the process. A nanobud synthesis reactor is operated at a furnace set temperature of 1000 °C, and the nanobud product is collected on two nitrocellulose filters in two synthesis processes. The reactor is operated at conditions where the nanobud product on one nitrocellulose filter has a concentration of approximately 1 fullerene per nm and on the other nitrocellulose filter the nanobud product has a concentration of approximately 1 fullerene per 10 nm. The resulting nanobud film 53 having approximately 1 fullerene per 10 nm is pressed against a transparent PE substrate 52 and the other nanobud film 53, having approximately 1 fullerene per nm is pressed against a platinum substrate 57. The nanobud films 53 are then transferred from the nitrocellulose filter to the PE 52 and platinum 57 substrates at room temperature. Both of the nanobud films 53 are first dipped in ethanol and then in nitric acid to create a transparent electrode comprising the PE substrate 52 and an opaque electrode comprising the platinum substrate 57. A thin buffer layer 54 of PEDOT:PSS is spin coated on the transparent electrode and dried at 100 °C in atmosphere. A solution of P3HT and toluene is spin coated on the PEDOT:PSS layer 54 in a nitrogen atmosphere to create an approximately 0.1 micron thick deposit 55. A third layer of nanobuds 56 collected from a nanobud synthesis reactor operated at a furnace set temperature of 1000 °C, and at conditions where the nanobud product has a concentration of approximately 1 fullerene per nm, is prepared on a glass filter. The third layer 56 is pressed against the P3HT layer 55 at 130 °C to transfer the layer 56 and imbed the third nanobud layer 56 into the P3HT layer 55. The nanobud film 53 on the platinum substrate 57 is then pressed against the P3HT/nanobud composite layer 58, and this resulting structure is used as a solar cell.

### Capacitor (Super Capacitor)

A super capacitor according to one embodiment of the present invention is made by depositing several layers of nanobuds. The procedure is schematically presented by the series of Figs. 11a to 11b, where Fig. 11a represents the cross sectional structure of the device in the beginning of the process, and Fig. 11b represents the cross sectional structure of the device at the end of the process. One conductive layer of nanobuds 50 is deposited on a substrate by collecting the aerosol product from a floating catalyst aerosols reactor on a nitrocellulose filter. In the following examples, the nanobuds are transfer deposited either on a non-conductive substrate (PE) 49 or a conductive substrate 49 (e.g. nanotubes, nanobuds, gold or aluminium). When transfer deposited on a non-conductive substrate 49, the nanobud layer 50 acts as both the collector and the porous electrode. In the case of a separate conductive collector, the first and second conductive collectors may be any highly conductive or superconductive material. Examples include conductive metals (e.g., copper, aluminium, nickel or stainless steel), superconductive ceramics, and the like. The super capacitor can be of other designs, ineluding, without limitation, stacked and spiral-wound configurations. The nanobuds may be deposited either on the conductive or non-conductive substrate 49 by other known techniques to form the anode and the cathode electrode layers. For efficient charge storage, ideally, each electrode should contain nanobuds with diameters corresponding to approximately three times the diameter of the corresponding ion responsible for charge storage in the electrode. The diameter of the nanobud molecule should be understood as the diameter of the tubular part of the molecule.

To form the electrolyte layer 51, any of a number of methods known in the art are possible according to the invention. In the following examples, an ionic liquid is generally understood to be a liquid composed almost entirely, if not completely, of ions. An ionic liquid commonly acts as both a salt and solvent or is said to be 100% salt and 100% solvent.

In one method (method 1) to form the electrolyte layer 51, a polymer host is dissolved in a solvent (preferably a solvent for the polymer host). In this example the solvent is 1-methyl-2-pyrrolidinone (NMP). Other solvents are possible. Various polymer hosts are possible. In this case PVdF-HFP/[EMIM][Tf2N]. PVdF-HFP is used. 0.34 g of PVdF-HFP powder is dissolved in 1.7 ml of NMP under magnetic stirring for three hours. When the polymer host is fully dissolved in the solvent, the solution is mixed with an appropriate amount of ionic liquid to allow gellation of the polymer with the ionic liquid. Various ionic liquids are possible (in this case [EMIM] [Tf2N] is used). The resulting polymer solution is then mixed with 0.8 ml of [EMIM] [Tf2N] under magnetic stirring for two hours to complete the polymer gellation with the ionic liquid. 0.4 ml of the obtained homogeneous polymer-solvent-ionic liquid mixture is then poured onto a substrate, in this case a piece of glass slide (surface area about 6.25 cm²). Heating this solution-containing glass slide at 110 °C under vacuum (22 InHg) for fifteen hours completely evaporates the solvent NMP and forms a uniform and transparent PVdF-HFP/[EMIM][Tf2N] film. The freestanding and self-supporting electrolyte film 51 is easily separated from the substrate for later assembly of the super capacitor.

Another method (method 2) for producing the electrolyte layer 51 is described here. In this method, inorganic particulate fillers are introduced into the previously described electrolyte from method 1 to enhance its mechanical strength and decrease the level of polymer crystallinity. Similar to method 1, a polymer solution is prepared by dissolving a polymer host, in this case 0.34 g of PVdF-HFP in a solvent (though other polymers and amounts are possible), in this case 1.7 ml of NMP (though other polymers and amounts are possible) and stirring for three hours (though longer or shorter times are possible). The resultant solution is mixed with an ionic liquid, in this case 0.8 ml [EMIM] [Tf2N] (though other ionic liquids and amounts are possible), and an appropriate amount of inorganic particulate (in this case 0.02 g zeolite was the inorganic particulate filler though other fillers and amounts are possible) for two hours ensuring the complete dispersion of the filler powder in the solution and the gellation of polymer with the ionic liquid. The resulting mixture is processed by solution casting on a non-adhesive substrate, in this case a glass slide with a surface area of 6.25 cm² (though other substrates are possible). The solvent-cast film is heated, in this case at 110 °C (though other temperatures are possible) under vacuum (though atmospheric and overpressure are possible) to evaporate essentially all of the solvent to form an inorganic filler-embodied electrolyte film. The obtained electrolyte layer 51 can be peeled easily from the substrate for later assembly of the super capacitor.

In a third method (method 3) for producing the electrolyte layer 51 a pre-made microporous and permeable polymer separator, in this case (PTFE) membrane (thickness: 23 µm, pore size: 0.05-15 µm, porosity: 50-70%) obtained from W.L. Gore & Associates (though other permeable membranes are possible), is impregnated with a selected ionic liquid (in this case 0.5 ml [EMIM] [Tf2N], though other ionic liquids and amounts are possible). The preformed, microporous and permeable polymer membrane is contacted with the ionic liquid by placing the membrane in a bath of the ionic liquid. In this case, this is done by soaking a piece of PTFE membrane (dimensions 2×2 cm²) in a pan containing the [EMIM] [Tf2N]. The polymer membrane, while contacted with the ionic liquid or ionic liquid/solvent mixture, is heated to directly swell/gell the polymer host, in this case at 110 °C and under vacuum (22 InHg) for fifteen hours (though other temperatures, times and pressure conditions are possible) to form the electrolyte layer 51. The resultant electrolyte membrane is removed from the ionic liquid and the excess ionic liquid on the membrane is removed, in this case by hanging the membrane for a few minutes (though other methods of removing the excess liquid are possible).

The super capacitor is assembled by sandwiching the anode and cathode nanobud electrodes 50 and electrolyte layer 51 between the two supporting substrates 49 which can be current collectors or non-conductive substrates (e.g. PE). Edges of the capacitor are sealed with epoxy (not shown in the figures). One piece of the electrolyte layer 51 (thickness: about 100 µm) can be used directly as a separator for capacitor fabrication.

Another means of producing super capacitors involves using plasma-etched nanobuds in the electrodes. The super capacitors are produced as in methods 1, 2 and 3 as disclosed above, however an additional etching step is applied with water or oxygen plasma to cause a controllable disintegration of the graphitic nanobud structure, leading to the opening of some fullerene parts and end-caps of the nanobud molecules.

The super capacitors fabricated according to the aforementioned exemplary methods can have highly attractive properties. By way of example, the power density of the super capacitors can be at least about 10 kW/kg with an energy density of at least about 10 Wh/kg.

As is clear for a person skilled in the art, the invention is not limited to the examples described above but the embodiments can freely vary within the scope of the claims.

## Claims

1. An electrical device, **characterized in that** said device is a transistor and comprises a deposit comprising carbon nanobud molecules, wherein said deposit forms a channel and the carbon nanobud molecules form a network of electrically conductive paths.

2. The electrical device of claim 1, **characterized in that** said deposit serves the function of carrier transport or carrier storage.

3. The electrical device of any one of claims 1 - 2, **characterized in that** said transistor is a field effect transistor (18).

4. The electrical device of any one of claims 1 - 3, **characterized in that** the carbon nanobud molecules form an essentially parallel array of electrically conductive paths.

5. The electrical device of any one of claims 1 - 4, **characterized in that** the carbon nanobud molecules are functionalized via at least one fullerene group so as to provide a means of exciting an electron by means of electromagnetic radiation.

6. The electrical device of any one of claims 1 - 5, **characterized in that** said deposit has an on-off ratio above 1, preferably above 1x10² and most preferably above 1x10⁴.

7. The electrical device of any one of claims 1 - 6 **characterized in that** the semiconductivity of said deposit is controllable by the density of the deposit, the length of the deposit in the direction of the conductive pathway, the width of the deposit in the direction perpendicular to the conductive pathway, the thickness of the deposit, by the concentration of fullerene or fullerene-like appendages and/or by the relative amount of conductive and semiconductive molecules in the deposit.
